# EUROPÄISCHE PATENTANMELDUNG

(11) **EP 4 513 159 A1**
(43) Veröffentlichungstag der Anmeldung: **26.02.2025**
(21) Anmeldenummer: 23192673.4
(22) Anmeldetag: 22.08.2023
(51) Int. Cl.: G01M 7/00, G01M 13/045, G01M 99/00, G04D 7/00, G04D 99/00, G06T 7/00, G06T 7/20, G06T 7/70, G01B 11/00

(54) **VORRICHTUNG UND VERFAHREN ZUR ERFASSUNG VON POSITIONSÄNDERUNGEN MINDESTENS EINES IN EINER BAUGRUPPE ANGEBRACHTEN BAUTEILS**

(71) Anmelder: Tschudin, Urs, 2540 Grenchen (CH)
(72) Erfinder: GEISER, Alain, 3280 Murten (CH)
(74) Vertreter: EGLI-EUROPEAN PATENT ATTORNEYS

(57) **Zusammenfassung**

Die vorliegende Erfindung betrifft eine Vorrichtung sowie ein Verfahren zur Erfassung von Positionsänderungen mindestens eines in einer Baugruppe angebrachten Bauteils. Die Baugruppe wird in der Vorrichtung positioniert, und eine Kamera wird kalibriert. Ein Bild der Baugruppe wird vor der Schwingungsbeaufschlagung aufgenommen. Die Baugruppe wird für eine festgelegte Zeitdauer und Intensität Schwingungen ausgesetzt. Ein Bild der Baugruppe wird nach der Schwingungsbeaufschlagung aufgenommen. Mit Hilfe einer Bildverarbeitungseinrichtung werden die beiden Bilder überlagert, und Unterschiede werden identifiziert. Die Ergebnisse werden auf einem Display angezeigt, wobei möglicherweise die Bauteile mit Positionsänderungen (oder möglicherweise diejenigen ohne Änderungen) visuell hervorgehoben werden. Der Benutzer überprüft die Ergebnisse und kann weitere Aktionen basierend auf den festgestellten Positionsänderungen ergreifen.

## Beschreibung

Die vorliegende Erfindung betrifft eine Vorrichtung sowie ein Verfahren zur Erfassung von Positionsänderungen mindestens eines in einer Baugruppe angebrachten Bauteils.

Baugruppen, die aus mehreren einzelnen Bauteilen bestehen, die in einer festen Positionsbeziehung zueinander montiert sind, spielen in vielen Industriezweigen eine entscheidende Rolle. Die Sicherstellung der festen Positionsbeziehung und der Stabilität der einzelnen Bauteile in einer Baugruppe hat verschiedene wichtige Auswirkungen.

Einerseits ist die korrekte Positionierung der Bauteile entscheidend für die ordnungsgemäße Funktion der Gesamteinheit. In der Automobilindustrie beispielsweise müssen Motorteile präzise zusammengebaut sein, um eine effiziente und leistungsstarke Funktion des Motors zu gewährleisten. In der Elektronikindustrie müssen Leiterplatten und Komponenten korrekt positioniert werden, um die elektrischen Verbindungen zu gewährleisten.

Andererseits ist in vielen Fällen auch die ästhetische Qualität der positionssicheren Verbindung von Bauteilen in einer Baugruppe von großer Bedeutung, insbesondere in der Konsumgüterindustrie oder bei öffentlichen Anwendungen. Eine präzise Montage und Positionsbeziehung sorgt für ein ansprechendes Erscheinungsbild und einen professionellen Eindruck.

Dazu werden die Bauteile durch geeignete Fügeverfahren (form-, kraft- und/oder stoffschlüssig) in ihrer Lage und Position in der Baugruppe festgelegt. Trotz sorgfältiger Fertigung und Qualitätsüberwachung kann es aufgrund fertigungsbedingter Unzulänglichkeiten zu Schwankungen in der Verbindungsfestigkeit der einzelnen Bauteile einer Baugruppe kommen. Diese Schwankungen können im Laufe der Lebensdauer der Baugruppe zu unerwünschten Positionsänderungen einzelner Bauteile bis hin zum vollständigen Lösen einzelner Bauteile aus der Baugruppe führen.

Die Auswirkungen dieser Unzulänglichkeiten können vielfältig sein. Wenn Bauteile sich aufgrund von lockeren Verbindungen verschieben oder lösen, kann dies zu Fehlfunktionen oder sogar zum vollständigen Versagen des fertigen Produkts führen. In sensiblen Anwendungen wie der Medizintechnik oder der Luft- und Raumfahrt können solche Funktionsstörungen schwerwiegende Konsequenzen haben. In Baugruppen, bei denen die äußere Erscheinung wichtig ist, wie beispielsweise bei Konsumgütern oder in der Architektur, können lockere oder verschobene Bauteile die ästhetische Qualität beeinträchtigen und das Gesamtbild beeinflussen.

Die letztgenannte Problematik der Gewährleistung einer jederzeit hohen ästhetischen Qualität ist vor allem in der Schmuck- und Uhrenindustrie, insbesondere bei teuren Luxusuhren, von entscheidender Bedeutung. Schließlich setzen Luxusuhrenhersteller häufig auf ihre Marke und Reputation als Hauptverkaufsargument und die ästhetische Qualität der Uhren ist eng mit der Wahrnehmung der Marke verbunden.

Diamanten und andere Edelsteine werden häufig in der Uhrenindustrie, insbesondere bei Luxusuhren, verwendet, um Ästhetik, Prestige und Wert zu steigern. Edelsteine können dem Zifferblatt, der Krone oder dem Gehäuse einer Uhr eine besondere Ästhetik verleihen, die es von anderen Uhren abhebt. Die Herausforderung besteht darin, dass diese Edelsteine sicher und fest in Uhrengehäusen, Kronen und Zifferblättern sitzen und sich im Laufe der Zeit nicht lockern oder verlagern.

Um die Edelsteine in den Uhren sicher und fest zu fixieren, werden verschiedene Techniken eingesetzt, und eine davon ist die Verwendung von Klauen (Krallen). Die Vier-Klauen-Fassung ist eine in der Schmuck- und Uhrenindustrie gängige Art der Befestigung von Solitär-Edelsteinen. So werden beispielsweise um jedes Loch in der Krone der Uhr vier Klauen angebracht werden, die einen Edelstein an Ort und Stelle halten und ihm gleichzeitig die Möglichkeit geben, das Licht in einer Weise zu brechen, die seine Brillanz maximiert.

Die Verwendung kleiner, unregelmäßig geschliffener Diamanten mit ungleichen Größen oder kleinen Schliffflächen stellt eine zusätzliche Herausforderung dar. Die unregelmäßige Form der Diamanten erfordert präzise Anpassungen der Klauen, um sicherzustellen, dass die Edelsteine sicher gehalten werden und sich nicht lösen können.

Die Uhrmacher und Schmuckdesigner müssen darauf achten, dass die Klauen gleichmäßig und sicher um den Edelstein herum gebogen werden, ohne den Stein zu beschädigen. Auch müssen sie sicherstellen, dass die Edelsteine gleichmäßig im Zifferblatt oder der Krone platziert sind, um ein ausgewogenes und ästhetisches Gesamtbild zu gewährleisten.

In der Schmuck- und Uhrenindustrie wird die Arbeit der Edelsteinfassung oft noch von Hand in großen Fabrikhallen von vielen Fachkräften durchgeführt. Die Fassung von Edelsteinen erfordert eine hohe handwerkliche Präzision und Sorgfalt, und das Arbeiten unter einem Mikroskop mit hoher Vergrößerung ermöglicht es den Fachkräften, die feinen Details zu erkennen und die Edelsteine sicher und ästhetisch ansprechend in den Schmuckstücken zu platzieren.

Bei der Herstellung hochwertiger und luxuriöser Uhren werden die Edelsteine zunächst in die Metallfassungen eingesetzt und dann mit den kleinen, biegsamen Metallklauen oder -zinken, welche die Steine von verschiedenen Seiten umfassen, sicher in Position gehalten. Nachdem die Steine in ihre Fassungen gesetzt wurden, wird der Teil der Uhr (zum Beispiel die Kronenvorrichtung), in dem die Steine sitzen, unter einem Mikroskop betrachtet. Dies ermöglicht eine hochpräzise Untersuchung der Positionierung jedes einzelnen Steins. Um die Festigkeit der Fassung zu testen, wird ein Druckluftstrahl auf die Steine gerichtet. Dieser Luftstrahl wird in verschiedene Richtungen geblasen, um die Steine auf ihre Positionssicherheit in den Klauen zu prüfen. Wenn sich ein Stein leicht bewegt oder locker erscheint, wird er markiert. Wenn ein Stein als locker oder unsicher identifiziert wurde, muss der gesamte Teil der Uhr (zum Beispiel die Kronenvorrichtung) zurück in die Fabrikation, wo der betroffene Stein neu gefasst wird. Die Fassung wird durch vorsichtiges Lösen der Klauen geöffnet, der lose Stein entfernt, die Fassung überarbeitet, und der Stein wird sicher und fest erneut eingesetzt.

Selbst wenn die Methode mit den Klauen und der Druckluftprüfung eine gängige und bewährte Praxis ist, um Edelsteine in Schmuckstücken (wie zum Beispiel Armbanduhren) zu befestigen und ihre Positionsstabilität zu überprüfen, gibt es immer noch potenzielle Probleme.

Obwohl der Druckluftstrahl ein nützliches Hilfsmittel ist, um vorläufig die Stabilität der Steine in der Fassung zu überprüfen, kann er nicht alle möglichen Alltagssituationen und Belastungen simulieren, denen ein Schmuckstück ausgesetzt sein könnte. In der Praxis können Schmuckstücke verschiedenen Belastungen ausgesetzt sein, die weit über das einfache Anblasen mit Druckluft hinausgehen. Insbesondere wiederkehrende Stöße oder Erschütterungen (Vibrationen) können die Stabilität der Steine beeinträchtigen. Ein Stein, der durch den Luftstrahl zunächst stabil erscheint, könnte sich unter solchen realen Bedingungen lösen oder bewegen.

Aufgabe der vorliegenden Erfindung ist es daher, eine Vorrichtung und ein Verfahren zur Erfassung von Positionsänderungen mindestens eines in einer Baugruppe angebrachten Bauteils bereitzustellen, die auf einfache und automatisierte Weise (ohne zwingende manuelle Intervention) die gewünschte Funktionalität und ästhetische Qualität der Baugruppe sicherstellen.

Gelöst wird diese Aufgabe im Hinblick auf die Vorrichtung zur Erfassung von Positionsänderungen mindestens eines in einer Baugruppe angebrachten Bauteils mit einer Vorrichtung, welche die Merkmale des unabhängigen Patentanspruchs 1 aufweist, und im Hinblick auf das Verfahren zur Erfassung von Positionsänderungen mindestens eines in einer Baugruppe angebrachten Bauteils mit einem Verfahren, welches die Merkmale des unabhängigen Patentanspruchs 9 aufweist.

Weitere vorteilhafte Ausgestaltungsformen der erfindungsgemäßen Vorrichtung und des erfindungsgemäßen Verfahrens sind in den Merkmalen der abhängigen Patentansprüche beschrieben.

Im Einzelnen umfasst eine erfindungsgemäße Vorrichtung zur Erfassung von Positionsänderungen mindestens eines in einer Baugruppe angebrachten Bauteils: mindestens einen Schwingungserreger zur Beaufschlagung der Baugruppe mit Schwingungsbewegungen; mindestens eine Bildaufnahmeeinrichtung zur Aufnahme von Bildern derselben Teil- oder Gesamtansicht der Baugruppe, in der das mindestens eine Bauteil angebracht ist, vor und nach der Beaufschlagung der Baugruppe mit Schwingungsbewegungen; eine Bildverarbeitungseinrichtung zur Überlagerung der vor und nach der Beaufschlagung der Baugruppe mit Schwingungsbewegungen aufgenommenen Bilder; und eine Bildwiedergabeeinrichtung zur Wiedergabe der überlagerten Bilder unter visueller Hervorhebung von einem oder mehreren Bauteilen, die entweder Positionsänderungen oder keine Positionsänderungen erfahren haben.

Die erfindungsgemäße Vorrichtung nutzt Vibrationen oder Schwingungsbewegungen, um Änderungen in der Position von Bauteilen in einer Baugruppe festzustellen. Bauteile, die nicht fest angebracht oder möglicherweise beschädigt sind, werden sich im Gegensatz zu fest montierten Bauteilen infolge der auf die Baugruppe übertragenen Schwingungen bewegen und somit nach erfolgter Schwingungsbeanspruchung andere Positionen als vor erfolgter Schwingungsbeanspruchung aufweisen. Um die Funktion der Erfassung der vorbeschriebenen Positionsänderungen zu erfüllen, besteht die erfindungsgemäße Vorrichtung aus mehreren zusammenwirkenden Komponenten (Schwingungserreger, Bildaufnahmeeinrichtung, Bildverarbeitungseinrichtung und Bildwiedergabeeinrichtung).

Die erfindungsgemäß vorgesehene Überlagerung von Bildern vor und nach der Schwingungsbeaufschlagung kann in der Messtechnik und Qualitätskontrolle eingesetzt werden, um mögliche Verschiebungen oder Bewegungen von Bauteilen in einer Baugruppe zu visualisieren und zu analysieren.

Eine erfindungsgemäße Vorrichtung kann wie folgt betrieben werden: Zunächst wird die zu untersuchende Baugruppe in der Vorrichtung positioniert, und die Bildaufnahmeeinrichtung (beispielsweise Kamera) wird kalibriert. Dann werden hochauflösende Bilder der Baugruppe vor der Schwingungsbeaufschlagung aufgenommen. Diese dienen als Referenzbilder, welche die Ausgangspositionen der Bauteile darstellen. Die Baugruppe wird einer kontrollierten Schwingungsbeanspruchung (mit definierter Zeitdauer und Intensität) ausgesetzt. Dies kann durch verschiedene Methoden, wie mechanische Anregung, Vibrationen oder ähnliche Verfahren, erfolgen. Nach der Schwingungsbeanspruchung werden erneut Bilder der Baugruppe aufgenommen. Diese Bilder repräsentieren die aktuellen Positionen der Bauteile nach der Belastung. Die Bilder vor und nach der Schwingungsbeanspruchung werden überlagert. Dies geschieht entweder manuell durch Bildbearbeitungssoftware oder automatisch mithilfe spezieller Algorithmen zur Bildregistrierung. Durch die Überlagerung werden die Verschiebungen oder Positionsänderungen der Bauteile sichtbar gemacht. Bauteile, die ihre Position nicht verändert haben, bleiben in der Überlagerung deckungsgleich und erscheinen unverändert. Hingegen werden Bauteile, die sich verschoben oder bewegt haben, durch Verschiebungen in der Überlagerung hervorgehoben. Um die Unterschiede besser sichtbar zu machen, können verschiedene Techniken angewendet werden, wie beispielsweise die Verwendung von Farb- oder Helligkeitsänderungen in den überlagerten Bildern. Die hervorgehobenen Bereiche zeigen die Positionen der Bauteile, die sich im Vergleich zu den Referenzbildern verändert haben.

Durch diese Bildüberlagerung und die visuelle Hervorhebung wird es einfacher, potenzielle Probleme oder Abweichungen in der Baugruppe zu identifizieren. Die Technik ermöglicht eine schnelle und effektive Qualitätskontrolle, Fehlerdiagnose oder Zustandsüberwachung von Baugruppen in verschiedenen technischen Anwendungen und kann in verschiedenen Branchen, wie der Automobilindustrie, Luft- und Raumfahrt, Elektronikherstellung oder anderen Bereichen, hilfreich sein, in denen die Präzision und Stabilität von Baugruppen von großer Bedeutung sind.

Die Bildverarbeitung und die Anwendung visueller Hervorhebungen bieten viele Vorteile bei der Analyse von Positionsänderungen in Baugruppen. Dabei ist die Qualität der aufgenommenen Bilder wichtig für genaue Ergebnisse. Klare und hochauflösende Bilder minimieren mögliche Fehler bei der Bildverarbeitung und erhöhen die Genauigkeit der Positionsbestimmung.

Eine besonders bevorzugte Ausführungsform der erfindungsgemäßen Vorrichtung umfasst weiterhin ein Mikroskop, wobei die Bildaufnahmeeinrichtung anstelle eines Mikroskopokulars oder unmittelbar hinter einem Mikroskopokular zur Aufnahme der vom Mikroskop erzeugten vergrößerten Bilder angeordnet ist.

Die Integration eines Mikroskops in die Vorrichtung stellt eine interessante Ergänzung dar, insbesondere wenn es darum geht, detaillierte Untersuchungen von Baugruppen oder Bauteilen durchzuführen, die eine hohe Vergrößerung erfordern. Indem die Bildaufnahmeeinrichtung anstelle des Mikroskopokulars oder direkt hinter dem Okular platziert wird, können vergrößerte Bilder, die vom Mikroskop erzeugt werden, erfasst und weiterverarbeitet werden.

Die Integration des Mikroskops in die Vorrichtung bietet verschiedene Vorteile. So ermöglichen Mikroskope die Betrachtung von Bauteilen oder Strukturen mit sehr hohen Vergrößerungen, was oft für die Analyse feinster Details oder Mikrostrukturen erforderlich ist. Die hohe Vergrößerung des Mikroskops ermöglicht eine genaue Beurteilung kleinster Positionsänderungen oder Verschiebungen in der Baugruppe. Durch die Vergrößerung können selbst kleinste Veränderungen in der Lage von Bauteilen oder Mikrostrukturen sichtbar gemacht werden, die mit bloßem Auge nur schwer zu erkennen sind. Die Vorrichtung kann sowohl für makroskopische als auch für mikroskopische Untersuchungen verwendet werden, je nach den Anforderungen der spezifischen Baugruppe oder des Bauteils. Durch die Aufnahme der vergrößerten Bilder können die Ergebnisse dokumentiert und später detailliert analysiert werden, was die Fehlersuche und Prozessoptimierung unterstützt.

In bevorzugter Weiterbildung der vorgenannten Ausführungsform weist das Mikroskop eine Trägereinheit für die Baugruppe auf, wobei die Trägereinheit mit dem Schwingungserreger mechanisch, elektrisch oder elektromechanisch gekoppelt ist oder der Schwingungserreger in die Trägereinheit integriert ist.

Das Mikroskop ist somit eine besondere Art von "Rüttelmikroskop", das in der Lage ist, die zu untersuchende Baugruppe oder Probe vor, während und nach der Beobachtung mechanischen Schwingungen auszusetzen. Durch diese Schwingungsanregung können bestimmte Effekte oder Verhaltensweisen der Baugruppe besser beobachtet und analysiert werden, insbesondere wenn es um dynamische oder resonante Phänomene geht.

Bei der mechanischen Kopplung wird die Trägereinheit, auf der die zu untersuchende Baugruppe platziert ist, durch mechanische Bauteile mit einem externen Schwingungserreger verbunden. Der Schwingungserreger kann beispielsweise eine Vibrationsplattform oder ein elektromechanischer Anregungskörper sein, der in der Lage ist, präzise Schwingungen zu erzeugen. Bei der elektrischen Kopplung erfolgt die Schwingungsanregung durch elektrische Signale, die auf die Trägereinheit übertragen werden. Die Trägereinheit kann mit elektromagnetischen Aktoren oder Piezoelementen ausgestattet sein, die durch Anlegen einer elektrischen Spannung Schwingungen erzeugen. Die elektromechanische Kopplung ist eine Kombination aus mechanischer und elektrischer Kopplung. Wird der Schwingungserreger direkt in die Mikros-kopträgereinheit integriert, so wird eine kompakte und gut kontrollierbare Lösung für die Schwingungsanregung vor, während und nach der Beobachtung möglich.

Darüber hinaus kann eine bevorzugte Ausführungsform der erfindungsgemäßen Vorrichtung weiterhin mindestens eine Belichtungseinrichtung zur Belichtung der von der Bildaufnahmeeinrichtung abgebildeten Teil- oder Gesamtansicht der Baugruppe umfassen.

Durch gezielte Belichtung können bestimmte Merkmale oder Strukturen in der Baugruppe hervorgehoben werden, was die Identifizierung von Positionsänderungen erleichtert. Eine gezielte Belichtung kann auch die Qualität und Aussagekraft der überlagerten Bilder verbessern, was wiederum die Genauigkeit und Effizienz der Positionsänderungsanalyse erhöht.

Die Integration einer Belichtungseinrichtung in die Vorrichtung kann somit zu einer weiteren Verbesserung der Qualität und Präzision der Ergebnisse führen. Dies ist insbesondere dann wichtig, wenn feine Details oder subtile Veränderungen in der Baugruppe erfasst werden müssen. Durch die Kombination von Schwingungserreger, Bildaufnahmeeinrichtung, Bildverarbeitungseinrichtung und Belichtungseinrichtung wird die Vorrichtung zu einem leistungsstarken Werkzeug für die Analyse und Qualitätskontrolle von Positionsänderungen in Baugruppen und Bauteilen.

Bei der vorbeschriebenen Ausführungsform kann zudem vorgesehen sein, dass die von der Belichtungseinrichtung durchgeführte Belichtung so eingestellt ist, dass bei der von der Bildverarbeitungseinrichtung durchgeführten und von der Bildwiedergabeeinrichtung wiedergegebenen Überlagerung der Bilder ein schwarzer Hintergrund entsteht, von dem sich nur die Bildbereiche, die entweder Positionsänderungen oder keine Positionsänderungen erfahren haben, als leuchtende Bildbereiche visuell abheben.

Diese Einstellung der Belichtungseinrichtung zur Erzeugung eines schwarzen Hintergrundes bei der Überlagerung der Bilder ist sehr vorteilhaft. Dadurch wird nämlich ein hoher Kontrast erzeugt, der es ermöglicht, die überlagerten Bilder besser zu visualisieren und die Unterschiede zwischen den Bildbereichen, die Positionsänderungen erfahren haben, und jenen, die positionsstabil geblieben sind, deutlich hervorzuheben.

Wenn die Belichtungseinrichtung so eingestellt ist, dass sie einen schwarzen Hintergrund erzeugt, sind die Bildbereiche, die durch die von der Bildverarbeitungseinrichtung durchgeführte Überlagerung als leuchtende Bildbereiche erzeugt werden, besonders gut sichtbar. Die Bildbereiche, die eine Positionsänderung erfahren haben oder positionsstabil geblieben sind, heben sich dadurch kontrastreich vom schwarzen Hintergrund ab.

Bei der Überlagerung der beiden Bilder wird beispielsweise ein Differenzbild erstellt. Dies bedeutet, dass für jeden Pixel im Bild der Unterschied zwischen den Helligkeitswerten (oder Farbwerten) der beiden Bilder berechnet wird. Wenn beide Bilder perfekt übereinstimmen (also kongruent sind), dann ist der Unterschied zwischen den beiden Bildern an jedem Pixel null. Wenn die Darstellung dieses "kein Unterschied"-Wertes als Schwarz interpretiert wird, dann wird ein vollständig kongruentes Bild komplett schwarz erscheinen. Wenn jedoch an irgendeiner Stelle eine Abweichung zwischen den Bildern festgestellt wird (zum Beispiel aufgrund einer Positionsänderung eines Bauteils), dann wird dieser Pixel nicht schwarz sein, sondern einen Helligkeits- und/oder Farbwert aufweisen, der den Grad der Abweichung widerspiegelt.

Dies macht es einfach, selbst kleine Änderungen visuell zu identifizieren. Die hell und/oder farbig leuchtenden Bildbereiche erleichtern das Erkennen von Verschiebungen oder Bewegungen der Bauteile und ermöglichen eine schnelle und effiziente Qualitätskontrolle. Gleichzeitig sorgt der schwarze Hintergrund für eine klare und übersichtliche Darstellung, die die Interpretation der überlagerten Bilder erleichtert.

Des Weiteren sieht eine besonders zweckmäßige Ausgestaltungsform der vorliegenden Erfindung vor, dass der Schwingungserreger als mechanischer Schwinger, magnetinduktiver Schwinger, pneumatischer Schwinger, piezoelektrischer Wandler oder elektroakustischer Wandler ausgebildet ist.

Jede dieser Ausgestaltungen hat ihre eigenen Eigenschaften und Funktionsweisen, um Schwingungsbewegungen auf die Baugruppe zu übertragen. Ein mechanischer Schwinger erzeugt Schwingungen durch mechanische Bewegungen, zum Beispiel durch eine Kurbel oder eine exzentrische Welle. Ein magnetinduktiver Schwinger erzeugt Schwingungen durch elektromagnetische Induktion, indem magnetische Felder und elektrische Ströme wechselwirken. Ein pneumatischer Schwinger erzeugt Schwingungen mithilfe von Druckluft oder anderen Gasen, die durch eine Ventilator- oder pneumatische Vorrichtung geleitet werden. Ein piezoelektrischer Wandler erzeugt Schwingungen durch den piezoelektrischen Effekt, bei dem ein piezoelektrisches Material sich mechanisch verformt, wenn es einer elektrischen Spannung ausgesetzt wird. Ein elektroakustischer Wandler erzeugt Schwingungen durch die Umwandlung elektrischer Signale in Schallwellen. Je nach den spezifischen Anforderungen und den zu untersuchenden Bauteilen kann eine geeignete Variante des Schwingungserregers in der Vorrichtung eingesetzt werden. Die grundlegende Funktionsweise der Vorrichtung bleibt unverändert, unabhängig von der Art des Schwingungserregers.

Gemäß einer weiteren besonders zweckmäßigen Ausgestaltungsform ist die Bildaufnahmeeinrichtung als Kamera, insbesondere hochauflösende Digitalkamera, ausgebildet, wobei die Kamera insbesondere zur Einstellung der gewünschten Ansicht bewegbar ist.

Durch die Verwendung einer bewegbaren hochauflösenden Digitalkamera kann die Vorrichtung die gewünschten Bilder der Baugruppe vor und nach den Schwingungsbewegungen aufnehmen und somit die Positionsänderungen der Bauteile präzise erfassen. Die Möglichkeit, die Kamera zu bewegen, bietet Flexibilität bei der Aufnahme der Bilder aus verschiedenen Blickwinkeln und ermöglicht es, spezifische Bereiche der Baugruppe genauer zu betrachten.

Die Bildverarbeitungseinrichtung kann dann die von der Kamera aufgenommenen Bilder überlagern und die Bildwiedergabeeinrichtung kann die überlagerten Bilder mit visueller Hervorhebung der Bauteile wiedergeben, die Positionsänderungen oder keine Positionsänderungen erfahren haben.

Diese Ausgestaltungsform ermöglicht somit eine genauere und umfassendere Analyse von Positionsänderungen in der Baugruppe und bietet damit eine effektive Technik zur Überwachung und Qualitätskontrolle von Baugruppen in verschiedenen Anwendungen.

Nach einer weiteren bevorzugten Ausführungsform der Erfindung ist vorgesehen, dass die Bildwiedergabeeinrichtung als Bildschirm, insbesondere hochauflösendes Display, ausgebildet ist.

Die Verwendung eines hochauflösenden Displays ermöglicht eine detaillierte und qualitativ hochwertige Darstellung der überlagerten Bilder.

Die Bildverarbeitungseinrichtung überlagert die vor und nach den Schwingungsbewegungen aufgenommenen Bilder, und diese überlagerten Bilder werden dann auf dem hochauflösenden Display wiedergegeben. Die visuelle Hervorhebung der Bauteile, die Positionsänderungen erfahren haben oder keine Positionsänderungen erfahren haben, wird auf dem Display deutlich sichtbar sein.

Durch die Verwendung eines hochauflösenden Displays als Bildwiedergabeeinrichtung wird eine klare und präzise Darstellung der Positionsänderungen ermöglicht, was die Analyse und Bewertung der Ergebnisse erleichtert. Dies ist besonders wichtig, um genaue Bewertungen vornehmen zu können und mögliche Abweichungen oder Probleme in den Verbindungen der Baugruppe zu erkennen.

Im Einzelnen umfasst ein erfindungsgemäßes Verfahren zur Erfassung von Positionsänderungen mindestens eines in einer Baugruppe angebrachten Bauteils: Beaufschlagung der Baugruppe mit Schwingungsbewegungen; Aufnahme von Bildern derselben Teil- oder Gesamtansicht der Baugruppe, in der das mindestens eine Bauteil angebracht ist, bevor und nachdem die Baugruppe mit Schwingungsbewegungen beaufschlagt wird; Überlagerung der Bilder, die vor und nach der Beaufschlagung der Baugruppe mit Schwingungsbewegungen aufgenommen werden; und Wiedergabe der überlagerten Bilder unter visueller Hervorhebung von einem oder mehreren Bauteilen, die entweder Positionsänderungen oder keine Positionsänderungen erfahren haben.

Die Verfahrensschritte des oben beschriebenen erfindungsgemäßen Verfahrens stimmen im Wesentlichen mit den Funktionen der Vorrichtungskomponenten der weiter oben beschriebenen erfindungsgemäßen Vorrichtung überein. Das erfindungsgemäße Verfahren weist daher die gleichen Vorteile auf, wie sie bereits weiter oben im Zusammenhang mit der erfindungsgemäßen Vorrichtung ausführlich dargelegt wurden.

Das erfindungsgemäße Verfahren verwendet also eine Art von differenzieller Bildverarbeitung oder Bildüberlagerung, um Veränderungen in den Positionen der Bauteile hervorzuheben. Dies kann insbesondere nützlich sein, um Bewegungen oder Veränderungen in einer Baugruppe sichtbar zu machen, insbesondere wenn diese Bewegungen klein oder subtil sind.

Bei der Wiedergabe der überlagerten Bilder werden Bauteile visuell hervorgehoben, die entweder Positionsänderungen erfahren haben oder keine Positionsänderungen erfahren haben.

Die visuelle Hervorhebung erleichtert die Identifizierung der betroffenen Bauteile und ermöglicht eine schnelle Überprüfung auf etwaige Probleme oder Abweichungen in der Baugruppe.

Insbesondere ermöglicht das erfindungsgemäße Verfahren eine effiziente und präzise Erfassung von Positionsänderungen in einer Baugruppe. Es kann in verschiedenen Anwendungen wie der Qualitätskontrolle, der Fertigung und der Ingenieurwissenschaft eingesetzt werden, um die Positionsstabilität und die Auswirkungen von Schwingungen auf Bauteile zu überwachen und zu analysieren.

Die visuelle Hervorhebung in den überlagerten Bildern, die mittels einer Bildwiedergabeeinrichtung wiedergegeben werden, ermöglicht eine einfache und eindeutige Identifizierung eines Bauteils, das eine unerwünschte Positionsänderung erfahren hat oder das keine Positionsänderung erfahren hat. Dieses Bauteil kann dann in der Baugruppe markiert werden. Das markierte Bauteil wird anschließend einer Nachbearbeitung unterzogen. Die Art der Nachbearbeitung kann je nach Anwendung variieren. Beispielsweise kann eine genauere Untersuchung des Bauteils durchgeführt werden, um festzustellen, ob die Positionsänderung tatsächlich relevant ist oder ob es sich um eine erlaubte Toleranz handelt. In einigen Fällen kann die Nachbearbeitung auch eine Reparatur oder Neuausrichtung des Bauteils umfassen, um die korrekte Positionierung zu gewährleisten.

Eine besonders bevorzugte Ausgestaltung der erfindungsgemäßen Vorrichtung oder des erfindungsgemäßen Verfahrens besteht darin, dass die Baugruppe ein Uhrmachereierzeugnis, insbesondere eine Armbanduhr, weiterhin insbesondere eine Kronenvorrichtung für eine Armbanduhr, ist und das mindestens eine Bauteil ein Zierelement, insbesondere ein Schmuckstein, weiterhin insbesondere ein Edelstein, ist, und wobei das Zierelement durch mehrere, insbesondere vier, Klauen im Uhrmachereierzeugnis gehalten ist.

Das Verfahren würde wie zuvor beschrieben ablaufen, indem die Armbanduhr, insbesondere ihre Kronenvorrichtung, Schwingungsbewegungen ausgesetzt wird, indem Bilder der Teil- oder Gesamtansicht der Armbanduhr, insbesondere ihrer Kronenvorrichtung, vor und nach der Beaufschlagung mit den Schwingungsbewegungen aufgenommen werden, indem die vor und nach den Schwingungsbewegungen aufgenommenen Bilder überlagert werden, um Veränderungen in den Positionen des oder der Zierelemente (Edelsteine) sichtbar zu machen, und indem die überlagerten Bilder auf einem hochauflösenden Display mit visueller Hervorhebung des oder der Zierelemente (Edelsteine) wiedergegeben werden, die unerwünschte Positionsänderungen erfahren haben.

Anschließend werden die entsprechenden Zierelemente (Edelsteine) in der Armbanduhr, insbesondere der Kronenvorrichtung, markiert und nachbearbeitet. Die Nachbearbeitung kann eine genauere Untersuchung des oder der Zierelemente (Edelsteine) umfassen, um festzustellen, ob die Positionsänderungen relevant sind oder innerhalb der zulässigen Toleranzen liegen. Je nach Bedarf können geeignete Maßnahmen ergriffen werden, um das oder die Zierelemente (Edelsteine) wieder richtig zu positionieren, gegebenenfalls zu reparieren oder zu ersetzen und so die Qualität und das ästhetische Erscheinungsbild der Armbanduhr zu gewährleisten.

In einer alternativen Ausgestaltung der erfindungsgemäßen Vorrichtung oder des erfindungsgemäßen Verfahrens ist vorgesehen, dass die Baugruppe eine elektrische oder elektronische Baugruppe, insbesondere eine bestückte Leiterplatte, ist und das mindestens eine Bauteil ein elektrisches oder elektronisches Bauteil, insbesondere eine auf einer Leiterplattenoberfläche montierte Komponente, ist.

Die erfindungsgemäße Vorrichtung und das erfindungsgemäße Verfahren können somit auf diese Alternative angewendet werden, um unerwünschte Positionsänderungen von elektrischen oder elektronischen Bauteilen auf einer bestückten Leiterplatte zu erkennen und zu überwachen. Die Oberfläche einer Leiterplatte kann mit einer Vielzahl von elektrischen oder elektronischen Bauteilen bestückt werden, je nach den Anforderungen und Funktionen der Leiterplatte. Hier wären beispielhaft zu nennen: Widerstände; Kondensatoren; Dioden; Transistoren; integrierte Schaltkreise (ICs); LEDs; Quarze und Oszillatoren; und Steckverbinder.

Die erfindungsgemäße Vorrichtung und das erfindungsgemäße Verfahren bieten in diesem Fall eine effektive Methode zur Qualitätskontrolle und zur Überprüfung der Positionsstabilität in elektrischen oder elektronischen Baugruppen. Dies ist besonders wichtig, um eine zuverlässige und fehlerfreie Funktion von elektrischen oder elektronischen Geräten zu gewährleisten. Die visuelle Hervorhebung ermöglicht eine einfache Identifikation der betroffenen Bauteile und erleichtert eine gezielte Analyse und Nachbearbeitung.

Schließlich ist in einer weiteren alternativen Ausgestaltung vorgesehen, dass die Baugruppe ein Wälzlager und das mindestens eine Bauteil ein Wälzkörper des Wälzlagers ist.

Wälzlager sind mechanische Komponenten, die in vielen Maschinen und Mechanismen eingesetzt werden, um die Reibung zwischen beweglichen Teilen zu reduzieren und eine reibungsarme Bewegung zu ermöglichen. Die Wälzkörper, die sich zwischen den Innen- und Außenringen des Lagers bewegen, sind das Herzstück des Lagers und ermöglichen die reibungsarme Bewegung. Abhängig von der Art des Lagers können die Wälzkörper Kugeln, Rollen, Zylinder oder Nadeln sein.

Die erfindungsgemäße Vorrichtung und das erfindungsgemäße Verfahren zielen hier darauf ab, "blockierte" Wälzkörper zu identifizieren, die fehlerhafterweise keine Positionsänderung erfahren haben. Solche "blockierten" Wälzkörper könnten aufgrund von Verschmutzungen, Beschädigungen oder anderen Faktoren in ihrer Bewegung eingeschränkt sein und dadurch die Funktionalität und Lebensdauer des Wälzlagers beeinträchtigen.

Durch eine geeignete Belichtung werden in den überlagerten Bildern die "blockierten" Wälzkörper visuell hervorgehoben. Durch die Überlagerung der vor und nach der Schwingungsbeaufschlagung des Wälzlagers aufgenommenen Bilder sind die "blockierten" Wälzkörper als solche identifizierbar, da sie infolge dieser Schwingungsbeaufschlagung keine Positionsänderungen erfahren haben.

Die visuelle Hervorhebung der "blockierten" Wälzkörper ermöglicht eine frühzeitige Erkennung möglicher Schäden oder Probleme im Wälzlager. Dadurch können gezielte Wartungsmaßnahmen ergriffen oder betroffene Wälzkörper ausgetauscht werden, um die Zuverlässigkeit und Lebensdauer des Wälzlagers zu erhöhen und Maschinenausfälle zu vermeiden.

Die erfindungsgemäße Vorrichtung und das erfindungsgemäße Verfahren bieten besonders vorteilhafte Anwendungen bei Uhrenkronenvorrichtungen für luxuriöse Armbanduhren, die auf der äußeren Stirnseite der Krone mit Edelsteinapplikationen versehen sind. In hochwertigen Armbanduhren werden häufig Edelsteine, wie Diamanten, Saphire oder Rubine, als Zierelemente in die Kronenvorrichtung eingearbeitet, um eine anspruchsvolle und luxuriöse Ästhetik zu erzielen. Die erfindungsgemäße Vorrichtung und das erfindungsgemäße Verfahren ermöglichen eine präzise und effiziente Überwachung der Positionsstabilität der Edelsteine in der Uhrenkronenvorrichtung.

Hierbei wird zunächst unter Verwendung eines mit einem Schwingungserreger, einer Kamera, einem Prozessor zur Bildverarbeitung und einem Bildschirm ausgerüsteten "Rüttelmikroskops" ein gestochen scharfes Bild der Krone mit den Edelsteinapplikationen aufgenommen. Die Krone wird anschließend für einige Sekunden mechanisch heftig vibriert (in Schwingung versetzt). Nach dem Vibrieren wird erneut ein Bild der Krone aufgenommen, um die Positionsänderungen der Edelsteine infolge des Vibrierens zu dokumentieren. Die beiden aufgenommenen Bilder (vor und nach dem Vibrieren) werden passend übereinander gelegt. Die übereinander gelegten Bilder werden auf dem Bildschirm des "Rüttelmikroskops" betrachtet. Bei einer vollständig kongruenten (deckungsgleichen) Überlagerung der Bilder ist der Bildschirm vollkommen schwarz. Wenn sich jedoch ein Edelstein durch das Vibrieren bewegt hat, leuchtet dieser Stein in den überlagerten Bildern auf und kann als bewegtes Bauteil identifiziert werden. Die bewegten Edelsteine können somit unter Verwendung des "Rüttelmikroskops" visuell hervorgehoben und anschließend vom Benutzer in der Kronenvorrichtung manuell markiert werden. Dadurch ist es möglich, die betroffenen Edelsteine gezielt nachzubearbeiten, beispielsweise durch eine Repositionierung oder eine weitere Prüfung auf Beschädigungen.

Die erfindungsgemäße Vorrichtung und das erfindungsgemäße Verfahren bieten eine äußerst präzise Methode zur Inspektion von Positionsänderungen in Uhrenkronenvorrichtungen mit Edelsteinapplikationen. Sie erlauben eine schnelle und genaue Bewertung der Positionsstabilität der Edelsteine und erleichtern die Durchführung von gezielten Maßnahmen zur Sicherstellung der ästhetischen und funktionalen Qualität von luxuriösen Armbanduhren. Die hohe Auflösung und die feine Darstellung des "Rüttelmikroskops" ermöglichen eine detaillierte Qualitätskontrolle und Inspektion, um die Perfektion und Exzellenz dieser hochwertigen Produkte zu gewährleisten.

Ein solches "Rüttelmikroskop", das Rüttelbewegungen (Schwingungsbewegungen) erzeugen kann und gleichzeitig über eine Bildüberlagerungsfunktion verfügt, hat ein breites Anwendungspotenzial und kann in zahlreichen Bereichen eingesetzt werden, um kleinste Positionsänderungen oder Blockierungen von Bauteilen zu erfassen. Neben der Uhrenindustrie und Schmuckherstellung, wie oben beschrieben, können auch andere Branchen von dieser innovativen Technologie profitieren.

Beispielsweise kann das "Rüttelmikroskop" mit Bildüberlagerungsfunktion in der Elektronikindustrie bei bestückten Leiterplatinen und anderen elektronischen Baugruppen verwendet werden, um festzustellen, ob elektrische oder elektronische Bauteile richtig fixiert sind und ob Klebe- oder Lötoperationen ausreichend und zuverlässig durchgeführt wurden. Durch die Identifizierung von lose sitzenden Bauteilen oder unzureichend verklebten oder verlöteten Bauteilen können mögliche Funktionsstörungen und Defekte vermieden werden.

Auch in der Lagertechnik bei Wälzlagern, insbesondere Kugellagern, kann das "Rüttelmikroskop" mit Bildüberlagerungsfunktion eingesetzt werden, um festzustellen, ob bestimmte Wälzkörper (Kugeln) "blockiert" oder nicht frei beweglich sind. Eine Blockade von Wälzkörpern (Kugeln) kann zu Reibung, Verschleiß und Beeinträchtigung der Lagerleistung führen. Durch die frühzeitige Erkennung solcher Probleme kann eine rechtzeitige Wartung oder Austausch der betroffenen Wälzköper (Kugeln) erfolgen, um die Funktionsfähigkeit des Wälzlagers (Kugellagers) sicherzustellen.

Die breiten Anwendungsbereiche zeigen, dass das "Rüttelmikroskop" mit Bildüberlagerungsfunktion eine äußerst vielseitige und nützliche Technologie ist. Die Identifizierung von Positionsänderungen oder Blockierungen von Bauteilen in verschiedenen industriellen Anwendungen kann zu einer verbesserten Qualitätskontrolle, erhöhten Produktzuverlässigkeit und verlängerten Lebensdauer von Baugruppen in verschiedenen Branchen führen.

## Patentansprüche

1. Vorrichtung zur Erfassung von Positionsänderungen mindestens eines in einer Baugruppe angebrachten Bauteils, wobei die Vorrichtung umfasst:
- mindestens einen Schwingungserreger zur Beaufschlagung der Baugruppe mit Schwingungsbewegungen;
- mindestens eine Bildaufnahmeeinrichtung zur Aufnahme von Bildern derselben Teil- oder Gesamtansicht der Baugruppe, in der das mindestens eine Bauteil angebracht ist, vor und nach der Beaufschlagung der Baugruppe mit Schwingungsbewegungen;
- eine Bildverarbeitungseinrichtung zur Überlagerung der vor und nach der Beaufschlagung der Baugruppe mit Schwingungsbewegungen aufgenommenen Bilder; und
- eine Bildwiedergabeeinrichtung zur Wiedergabe der überlagerten Bilder unter visueller Hervorhebung von einem oder mehreren Bauteilen, die entweder Positionsänderungen oder keine Positionsänderungen erfahren haben.

2. Vorrichtung nach Anspruch 1, weiterhin umfassend ein Mikroskop, wobei die Bildaufnahmeeinrichtung anstelle eines Mikroskopokulars oder unmittelbar hinter einem Mikroskopokular zur Aufnahme der vom Mikroskop erzeugten vergrößerten Bilder angeordnet ist.

3. Vorrichtung nach Anspruch 2, wobei das Mikroskop eine Trägereinheit für die Baugruppe aufweist und wobei die Trägereinheit mit dem Schwingungserreger mechanisch, elektrisch oder elektromechanisch gekoppelt ist oder der Schwingungserreger in die Trägereinheit integriert ist.

4. Vorrichtung nach einem der Ansprüche 1 bis 3, weiterhin umfassend mindestens eine Belichtungseinrichtung zur Belichtung der von der Bildaufnahmeeinrichtung abgebildeten Teil- oder Gesamtansicht der Baugruppe.

5. Vorrichtung nach Anspruch 4, wobei die von der Belichtungseinrichtung durchgeführte Belichtung so eingestellt ist, dass bei der von der Bildverarbeitungseinrichtung durchgeführten und von der Bildwiedergabeeinrichtung wiedergegebenen Überlagerung der Bilder ein schwarzer Hintergrund entsteht, von dem sich nur die Bildbereiche, die entweder Positionsänderungen oder keine Positionsänderungen erfahren haben, als leuchtende Bildbereiche visuell abheben.

6. Vorrichtung nach einem der Ansprüche 1 bis 5, wobei der Schwingungserreger als mechanischer Schwinger, magnetinduktiver Schwinger, pneumatischer Schwinger, piezoelektrischer Wandler oder elektroakustischer Wandler ausgebildet ist.

7. Vorrichtung nach Anspruch 1, wobei die Bildaufnahmeeinrichtung als Kamera, insbesondere hochauflösende Digitalkamera, ausgebildet ist und die Kamera insbesondere zur Einstellung der gewünschten Ansicht bewegbar ist.

8. Vorrichtung nach Anspruch 1, wobei die Bildwiedergabeeinrichtung als Bildschirm, insbesondere hochauflösendes Display, ausgebildet ist.

9. Verfahren zur Erfassung von Positionsänderungen mindestens eines in einer Baugruppe angebrachten Bauteils, wobei das Verfahren umfasst:
- Beaufschlagung der Baugruppe mit Schwingungsbewegungen;
- Aufnahme von Bildern derselben Teil- oder Gesamtansicht der Baugruppe, in der das mindestens eine Bauteil angebracht ist, bevor und nachdem die Baugruppe mit Schwingungsbewegungen beaufschlagt wird;
- Überlagerung der Bilder, die vor und nach der Beaufschlagung der Baugruppe mit Schwingungsbewegungen aufgenommen werden; und
- Wiedergabe der überlagerten Bilder unter visueller Hervorhebung von einem oder mehreren Bauteilen, die entweder Positionsänderungen oder keine Positionsänderungen erfahren haben.

10. Verfahren nach Anspruch 9, wobei das mindestens eine in den wiedergegebenen überlagerten Bildern visuell hervorgehobene Bauteil in der Baugruppe markiert wird und das mindestens eine markierte Bauteil anschließend einer Nachbearbeitung unterzogen wird.

11. Vorrichtung nach einem der Ansprüche 1 bis 8 oder Verfahren nach Anspruch 9 oder 10, wobei die Baugruppe ein Uhrmachereierzeugnis, insbesondere eine Armbanduhr, weiterhin insbesondere eine Kronenvorrichtung für eine Armbanduhr, ist und das mindestens eine Bauteil ein Zierelement, insbesondere ein Schmuckstein, weiterhin insbesondere ein Edelstein, ist, und wobei das Zierelement durch mehrere, insbesondere vier, Klauen im Uhrmachereierzeugnis gehalten ist.

12. Vorrichtung nach einem der Ansprüche 1 bis 9 oder Verfahren nach Anspruch 11 oder 12, wobei die Baugruppe eine elektrische oder elektronische Baugruppe, insbesondere eine bestückte Leiterplatte, ist und das mindestens eine Bauteil ein elektrisches oder elektronisches Bauteil, insbesondere eine auf einer Leiterplattenoberfläche montierte Komponente, ist.

13. Vorrichtung nach einem der Ansprüche 1 bis 9 oder Verfahren nach Anspruch 11 oder 12, wobei die Baugruppe ein Wälzlager und das mindestens eine Bauteil ein Wälzkörper des Wälzlagers ist.
